# EUROPEAN PATENT APPLICATION

(11) **EP 4 485 717 A1**
(43) Date of publication of application: **01.01.2025**
(21) Application number: 22928978.0
(22) Date of filing: 27.12.2022
(51) Int. Cl.: H01S 5/042, H01S 5/0237, H01S 5/183

(54) **LIGHT-EMITTING DEVICE AND VOS (VCSEL-ON-SILICON) DEVICE**

(30) Priority: 22.02.2022 JP 2022025202
(71) Applicant: Sony Semiconductor Solutions Corporation, Atsugi-shi, Kanagawa 243-0014 (JP)
(72) Inventor: AOYAGI, Akiyoshi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/048339
(87) International publication number: WO 2023/162463

(57) **Abstract**

Reliability of a connection is improved in a light emitting device connected to a laser driver. The light emitting device includes a solder wet layer, an adhesive layer, and a solder barrier layer. In the light emitting device, the solder wet layer is connected by solder.

Additionally, in the light emitting device, the adhesive layer is constituted by one of a tantalum nitride layer and two layers, which are a titanium layer and a titanium nitride layer. Additionally, in the light emitting device, the solder barrier layer is formed between the solder wet layer and the adhesive layer.

## Description

### [Technical Field]

The present technique relates to a light emitting device. In particular, the present technique relates to a light emitting device and a VoS device mounted on a silicon substrate.

### [Background Art]

Vertical Cavity Surface Emitting Lasers (VCSELs) are often used as light emitting devices when arranging light emitting devices in a two-dimensional array in a laser apparatus or the like. For example, a laser apparatus has been proposed in which a plurality of light emitting devices are mounted in a two-dimensional array on a laser chip and the laser chip is connected to a laser driver (see PTL 1, for example). In this laser apparatus, each of light emitting devices is connected to the laser driver by bumps. Of the light emitting device, a metal layer connected by the bumps and solder is constituted by layering Ti (titanium), Pt (platinum), and Au (gold) in this order from the laser chip side.

### [Citation List]

### [Patent Literature]

[PTL 1]
WO 2021/090670

### [Summary]

### [Technical Problem]

In the conventional technique described above, the laser chip and the laser driver are electrically connected by bumps, because it is intended to reduce resistance produced by wiring routing, as compared to when using wire bonding. However, when solder is used for the bumps, the Pt layer diffuses quickly into the solder, and separation may arise at the interface between the Ti layer and the Pt layer when left at high temperatures or due to repeated reflow, which may reduce the reliability of the connection with the laser driver.

The present technique has been made in light of such circumstances, and an object thereof is to improve the reliability of the connection of a light emitting device that is to be connected to a laser driver.

### [Solution to Problem]

The present technique has been made to solve the problems described above, and a first aspect thereof is a light emitting device including: a solder wet layer connected by solder; an adhesive layer constituted by one of a tantalum nitride layer ands two layers, which are a titanium layer and a titanium nitride layer; and a solder barrier layer formed between the solder wet layer and the adhesive layer. This provides an effect in that the reliability is improved.

In this first aspect, the solder barrier layer may contain at least one of cobalt, platinum, tantalum, and tungsten. This provides an effect of slowing the diffusion of the solder.

Additionally, in this first aspect, the solder wet layer may contain at least one of gold, platinum, and copper. This provides an effect in that gold, platinum, copper, and the like can be connected by the solder.

Additionally, a second aspect of the present technique is a light emitting device including: a solder wet layer connected to a silicon substrate by solder; an adhesive layer constituted by a titanium layer; and a solder barrier layer containing at least one of cobalt, tantalum, and tungsten, and formed between the solder wet layer and the adhesive layer. This provides an effect in that the reliability is improved.

Additionally, in this second aspect, the solder wet layer may contain at least one of gold, platinum, and copper. This provides an effect in that gold, platinum, copper, and the like can be connected by the solder.

Additionally, a third aspect of the present technique is a VCSEL on Silicon (VoS) device including: a light emitting device having a solder wet layer connected by solder, an adhesive layer constituted by one of a tantalum nitride layer and two layers, which are a titanium layer and a titanium nitride layer, and a solder barrier layer formed between the solder wet layer and the adhesive layer; and a silicon substrate on which the light emitting device is provided. This provides an effect in that the reliability is improved.

Additionally, a fourth aspect of the present technique is a VCSEL on Silicon (VoS) device including: a light emitting device having a solder wet layer connected by solder, an adhesive layer constituted by a titanium layer, and a solder barrier layer containing at least one of cobalt, platinum, tantalum, and tungsten, and formed between the solder wet layer and the adhesive layer; and a silicon substrate on which the light emitting device is provided. This provides an effect in that the reliability is improved.

### [Brief Description of Drawings]

[Fig. 1]

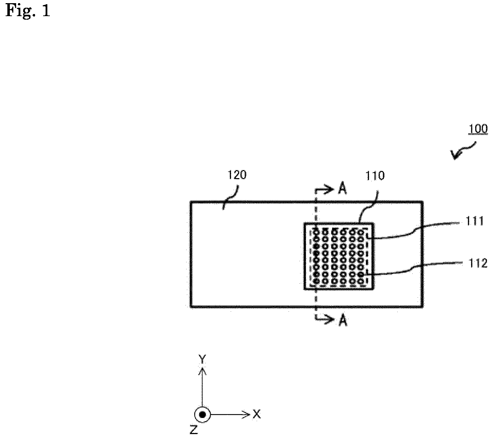

   Fig. 1 is a diagram illustrating an example of the planar configuration of a surface-emitting laser apparatus according to a first embodiment of the present technique.
[Fig. 2]

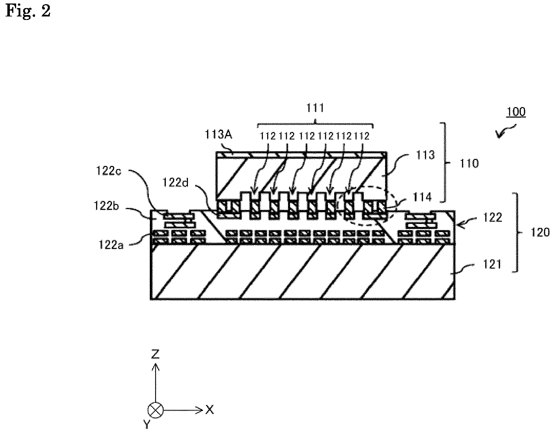

   Fig. 2 is a diagram illustrating an example of a cross-sectional configuration taken along a line A-A in Fig. 1, according to the first embodiment of the present technique.
[Fig. 3]

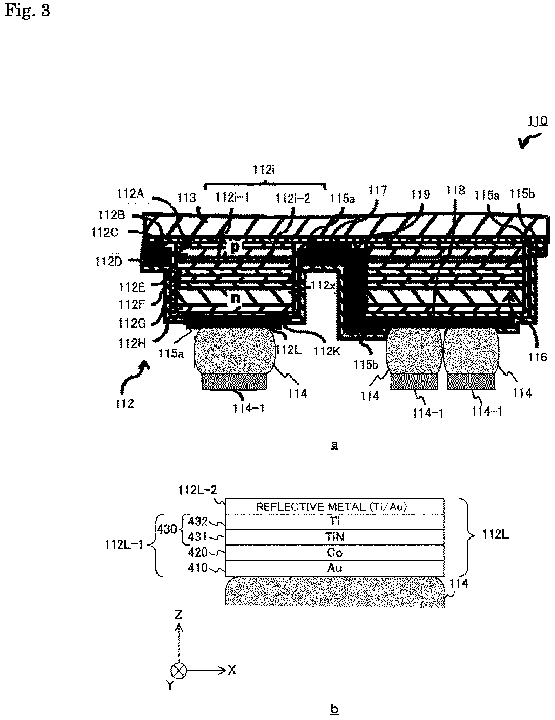

   Fig. 3 is a diagram illustrating an example of a cross-sectional configuration of an emitter illustrated in Fig. 2 and the periphery thereof, according to the first embodiment of the present technique.
[Fig. 4]

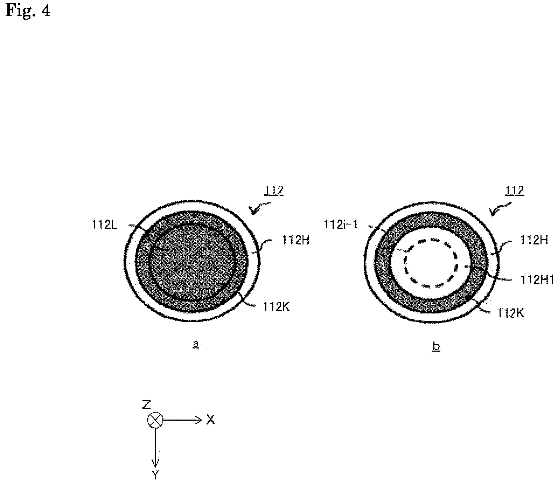

   Fig. 4 is a diagram illustrating an example of the planar configuration of the first embodiment of the present technique.
[Fig. 5]

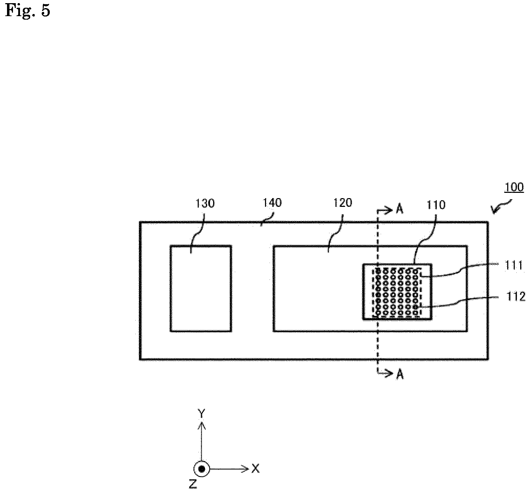

   Fig. 5 is a diagram illustrating an example of the planar configuration when a laser driver IC illustrated Fig. 1 is mounted onto a printed circuit board, according to the first embodiment of the present technique.
[Fig. 6]

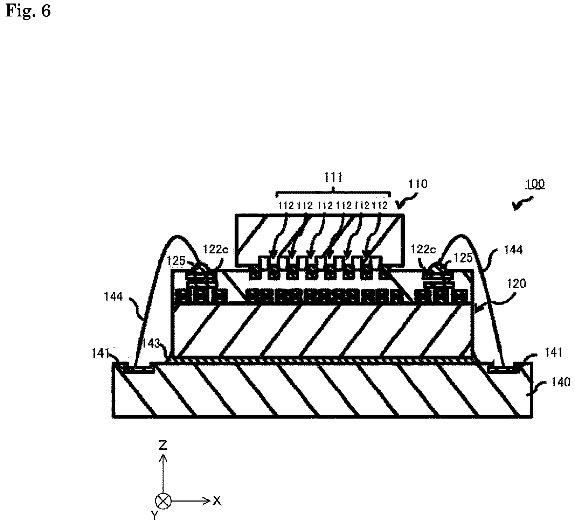

   Fig. 6 is a diagram illustrating an example of a cross-sectional configuration taken along a line A-A in Fig. 5, according to the first embodiment of the present technique.
[Fig. 7]

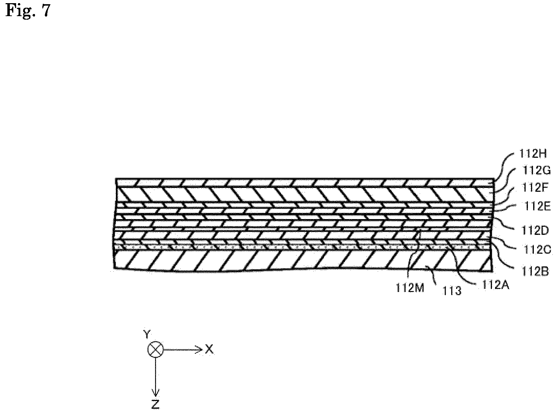

   Fig. 7 is a cross-sectional view illustrating an example of a method for manufacturing a laser chip illustrated in Fig. 3, according to the first embodiment of the present technique.
[Fig. 8]

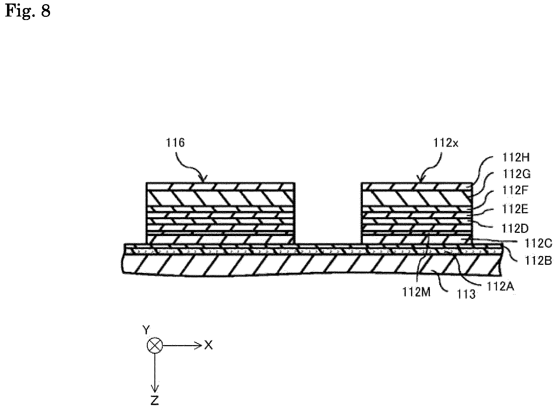

   Fig. 8 is a cross-sectional view illustrating an example of the manufacturing process following Fig. 7, according to the first embodiment of the present technique.
[Fig. 9]

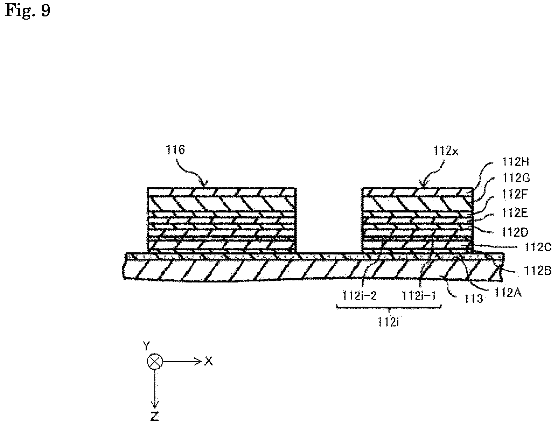

   Fig. 9 is a cross-sectional view illustrating an example of the manufacturing process following Fig. 8, according to the first embodiment of the present technique.
[Fig. 10]

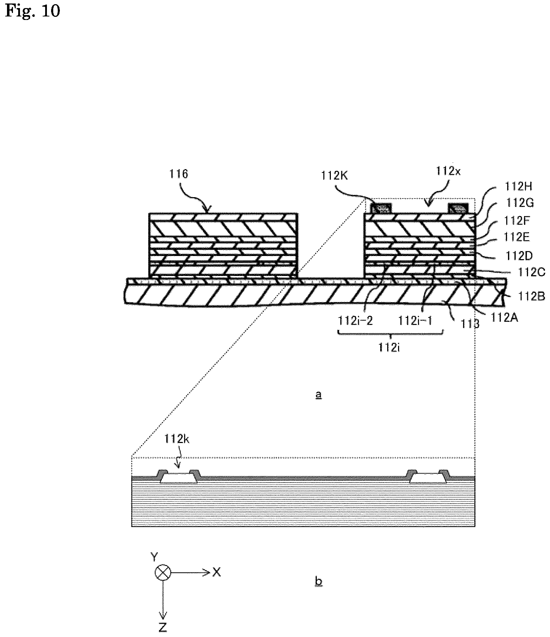

   Fig. 10 is a cross-sectional view illustrating an example of the manufacturing process following Fig. 9, according to the first embodiment of the present technique.
[Fig. 11]

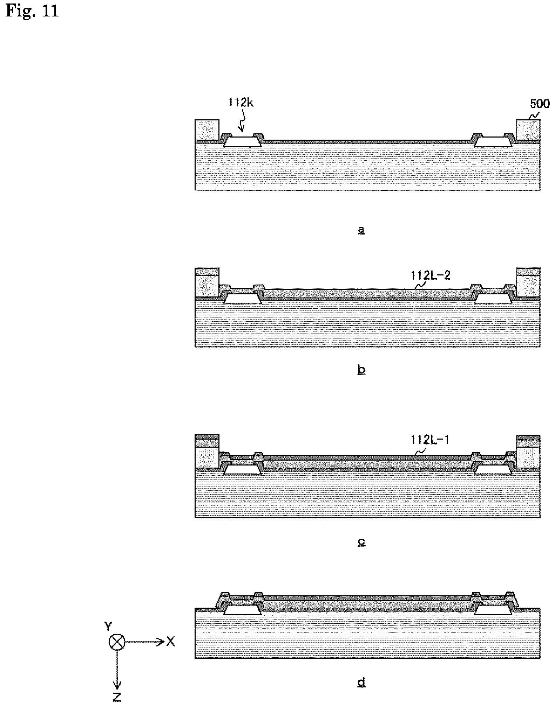

   Fig. 11 is a cross-sectional view illustrating an example of the manufacturing process following Fig. 10, according to the first embodiment of the present technique.
[Fig. 12]

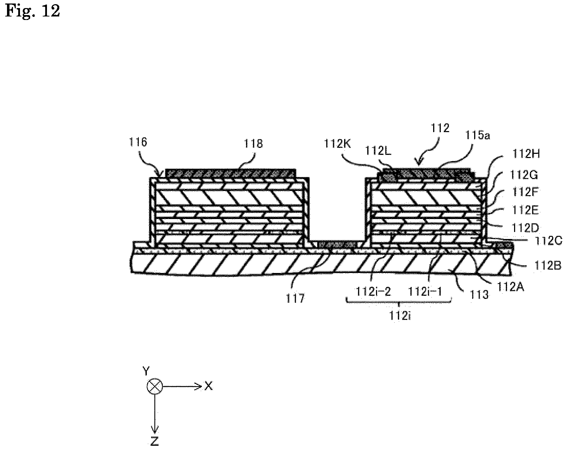

   Fig. 12 is a cross-sectional view illustrating an example of the manufacturing process following Fig. 11, according to the first embodiment of the present technique.
[Fig. 13]

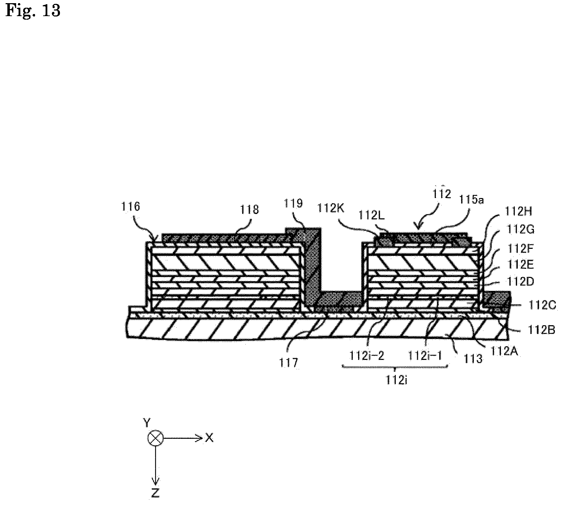

   Fig. 13 is a cross-sectional view illustrating an example of the manufacturing process following Fig. 12, according to the first embodiment of the present technique.
[Fig. 14]

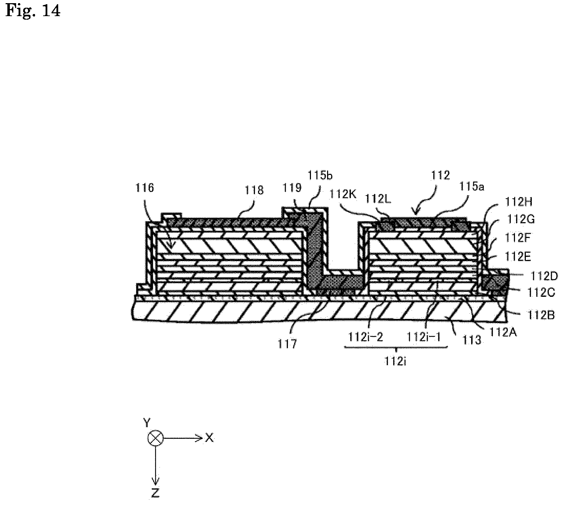

   Fig. 14 is a cross-sectional view illustrating an example of the manufacturing process following Fig. 13, according to the first embodiment of the present technique.
[Fig. 15]

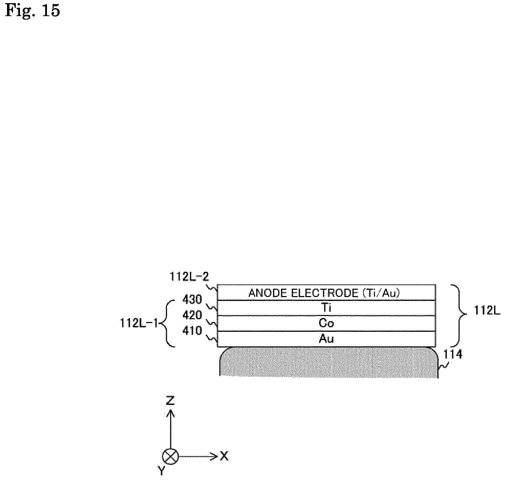

   Fig. 15 is a cross-sectional view illustrating an example of the configuration of a metal layer according to a second embodiment of the present technique.
[Fig. 16]

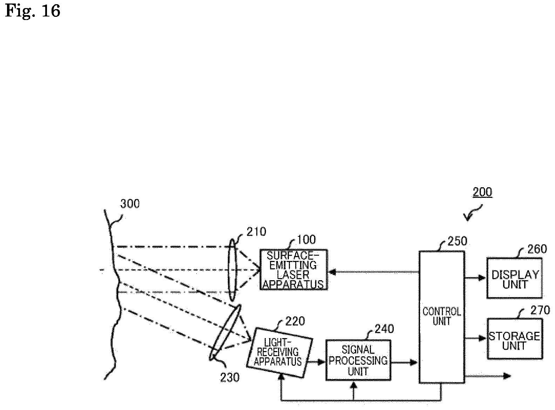

   Fig. 16 is a diagram illustrating an example of the application of the surface-emitting laser apparatus according to the foregoing embodiments to a distance measurement apparatus.
[Fig. 17]

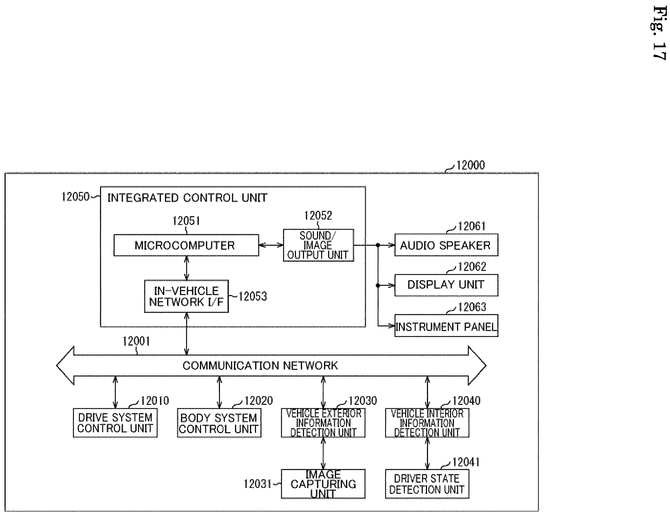

   Fig. 17 is a block diagram illustrating an example of the schematic configuration of a vehicle control system.
[Fig. 18]

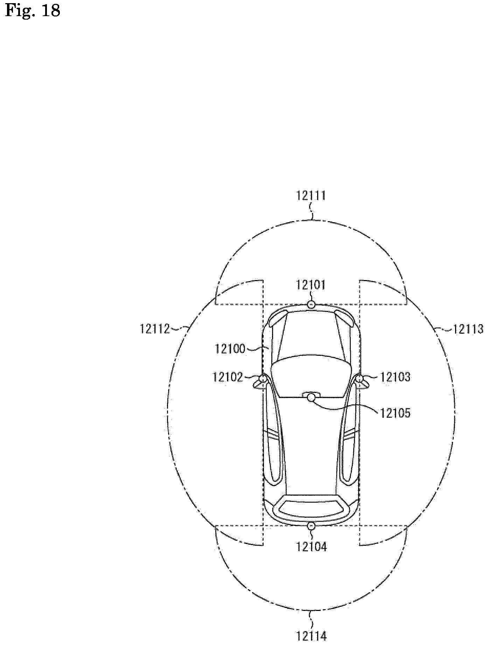

   Fig. 18 is an explanatory diagram illustrating an example of installation positions of image capturing units.

### [Description of Embodiments]

Modes for carrying out the present technique (called "embodiments" hereinafter) will be described hereinafter. The descriptions will be given in the following order.
1. First Embodiment (Example of Forming Ti/TiN or TaN Adhesive Layer)
2. Second Embodiment (Example of Forming Solder Barrier Layer Including at Least One of Co, Ta, or W)
3. Application Example
4. Example of Application in Moving Body

### <1. First Embodiment>

### [Example of Configuration of Surface-Emitting Laser Apparatus]

A surface-emitting laser apparatus 100 according to an embodiment of the present disclosure will be described next. Fig. 1 illustrates an example of the configuration of the top surface of the surface-emitting laser apparatus 100. Fig. 2 illustrates an example of the cross-sectional configuration of the surface-emitting laser apparatus 100 seen along the line A-A in Fig. 1.

The surface-emitting laser apparatus 100 is a back-emitting type laser that can be suitably applied in applications requiring a thin size and low power consumption, applications requiring a thin size over a large surface area, and the like. The surface-emitting laser apparatus 100 includes a laser chip 110 and a laser driver integrated circuit (IC) 120. In the present embodiment, the laser chip 110 is disposed on the laser driver IC 120. The laser chip 110 is electrically connected to the laser driver IC 120 by a plurality of solder bumps 114, for example. Hereinafter, a predetermined axis parallel to the chip plane of the laser chip 110 will be referred to as an "X axis", and an axis perpendicular to the chip plane will be referred to as a "Z axis". An axis perpendicular to both the X axis and the Z axis will be referred to as a "Y axis". Fig. 1 is a plan view seen from the Z-axis direction, and Fig. 2 is a cross-sectional view seen from the Y-axis direction.

The laser chip 110 includes, for example, a substrate 113, an emitter array 111 formed on the laser driver IC 120 side surface of the substrate 113, the plurality of solder bumps 114 formed on the laser driver IC 120 side surface of the substrate 113, and an Anti-Reflection (AR) layer 113A formed on the surface of the substrate 113 opposite from the surface on which the laser driver IC 120 is formed (i.e., a light-emitting surface). The emitter array 111 is disposed on the surface of the substrate 113 opposite from the light-emitting surface. The AR, layer 113A is constituted by a layered body in which SiO₂ and SiN are layered, for example.

The emitter array 111 is constituted by a plurality of emitters 112 disposed on the same substrate 113, as illustrated in Figs. 1 and 2, for example. The plurality of emitters 112 are disposed on the substrate 113 at equal intervals in both a row direction and a column direction, for example. Note that the plurality of emitters 112 may disposed at random on the same substrate 113. Each emitter 112 is constituted by a surface-emitting semiconductor laser, i.e., a VCSEL, that emits a laser beam in the layering direction. In the present embodiment, each emitter 112 emits a laser beam toward the side opposite from the side on which the laser driver IC 120 is located, through the substrate 113 and the AR, layer 113A. The substrate 113 is constituted by, for example, a semi-insulative semiconductor substrate that transmits the light emitted from the emitters 112 (e.g., a Si-GaAs substrate). Note that the emitter 112 is an example of a light emitting device according to the claims, and the substrate 113 is an example of a "silicon substrate" according to the claims. The surface-emitting laser apparatus 100 is an example of a VoS device according to the claims.

Each emitter 112 has a cylindrical vertical resonator structure (mesa part 112x) in which an etching stop layer 112B, a Distributed Bragg Reflector (DBR) layer 112C, a spacer layer 112D, an active layer 112E, a spacer layer 112F, a DBR layer 112G, and a contact layer 112H are layered in that order from the substrate 113 side, as illustrated in a in Fig. 3, for example. The diameter (mesa diameter) of each mesa part 112x is slightly smaller than the beam pitch of the laser beams emitted from the mesa parts 112x. For example, when the beam pitch is set to be about 18 µm, the diameter of each mesa part 112x (the mesa diameter) is about 14 µm. In each mesa part 112x, the active layer 112E is interposed between the DBR layers 112C and 112G. Each emitter 112 has a contact layer 112Athat is in contact with the etching stop layer 112B. The contact layer 112A is a layer for bringing each mesa part 112x (and specifically, the DBR layer 112C, which will be described later) into ohmic contact with an electrode layer 117 (described later). The contact layer 112A is provided between each mesa part 112x and the substrate 113, and is in contact with each mesa part 112x and the substrate 113. The substrate 113 is provided in contact with the side of the contact layer 112A opposite from the side on which the active layer 112E is located.

The emitters 112 share the contact layer 112A. In other words, the plurality of mesa parts 112x are disposed on the same contact layer 112A, and in the laser chip 110, each mesa part 112x protrudes toward the laser driver IC 120 side. In each mesa part 112x, the contact layer 112H is an end face on the laser driver IC 120 side. Hereinafter, the end face of the mesa part 112x on the laser driver IC 120 side may be referred to as a top surface of the mesa part 112x for convenience. In each emitter 112, a current confinement layer 112i is provided within the DBR layer 112G. Note that Fig. 3 illustrates an example of the cross-sectional configuration of the part of the laser chip 110 illustrated in Fig. 2 that is surrounded by the broken line. In the present embodiment, each mesa part 112x is formed using the substrate 113 as a crystalline growth substrate, for example.

Each mesa part 112x and the contact layer 112A are constituted by, for example, a GaAs-based semiconductor. The contact layer 112Ais constituted by, for example, p-type Alₓ₁Ga₁₋ₓ₁As (0 ≤ x1 < 1). The etching stop layer 112B is constituted by, for example, p-type Inₓ₂Ga₁₋ₓ₂P (0 < x2 < 1). The DBR layer 112C is constituted by layering a low refractive index layer (not shown) and a high refractive index layer (not shown) in an alternating manner. In the DBR layer 112C, the low refractive index layer is constituted by p-type Alₓ₃Ga₁₋ₓ₃As (0 < x3 < 1) having an optical thickness of λ×1/4 (where λ1 is the oscillation wavelength), and the high refractive index layer is constituted by, for example, p-type Alₓ₄Ga₁₋ₓ₄As (0 ≤ x4 < x3) having an optical thickness of λ×1/4, for example. The spacer layer 112D is constituted by, for example, p-type Alₓ₅Ga₁₋ₓ₅As (0 ≤ x5 < 1). The contact layer 112A, the etching stop layer 112B, the DBR layer 112C, and the spacer layer 112D contain p-type impurities such as carbon (C), for example. In other words, the contact layer 112A, the etching stop layer 112B, the DBR layer 112C, and the spacer layer 112D are constituted by p-type semiconductors.

The active layer 112E has a multiple quantum well structure in which, for example, a well layer (not shown) constituted by undoped Inₓ₆Ga₁₋ₓ₆As (0 < x6 < 1) and a barrier layer (not shown) constituted by undoped Inₓ₇Ga₁₋ₓ₇As (0 < x7 < x6) are layered in an alternating manner. Note that a region in the active layer 112E, opposite a current injection region 112i-1 (described later), is a light emitting region.

The spacer layer 112F is constituted by, for example, n-type Alₓ₈Ga₁₋ₓ₈As (0 ≤ x8 < 1). The DBR layer 112G is constituted by layering a low refractive index layer (not shown) and a high refractive index layer (not shown) in an alternating manner. In the DBR layer 112G, the low refractive index layer is constituted by, for example, n-type Alx₉Ga₁₋ₓ₉As (0 < x9 < 1) having an optical thickness of λ×1/4, and the high refractive index layer is constituted by, for example, n-type Alₓ₁₀Ga₁₋ₓ₁₀As (0 ≤ x10 < x9) having an optical thickness of λ×1/4. The contact layer 112H is a layer for bringing the DBR layer 112G into ohmic contact with a ring electrode layer 112K. The contact layer 112H is constituted by, for example, n-type Alₓ₁₁Ga₁₋ₓ₁₁As (0 ≤ x11 < 1). The spacer layer 112F, the DBR layer 112G, and the contact layer 112H contain n-type impurities such as silicon (Si), for example. In other words, the spacer layer 112F, the DBR layer 112G, and the contact layer 112H are constituted by n-type semiconductors.

The number of pairs of the low refractive index layer and the high refractive index layer in the DBR layer 112G is lower than the number of pairs of the low refractive index layer and the high refractive index layer in the DBR layer 112C, for example. The number of pairs in the DBR layer 112G is less than or equal to half the number of pairs necessary to form a DBR layer when an insulating film 115a and a metal layer 112L (described later) are not provided. This is because the insulating film 115a and the metal layer 112L supplement the light reflection function of the DBR layer 112G, and the number of pairs of the low refractive index layer and the high refractive index layer in the DBR layer 112G can be reduced by an amount corresponding to the light reflection capability of the insulating film 115a and the metal layer 112L.

The current confinement layer 112i has the current injection region 112i-1 and a current confinement region 112i-2. The current confinement region 112i-2 is formed in a peripheral region of the current injection region 112i-1. The current injection region 112i-1 is constituted by, for example, p-type Alₓ₁₂Ga₁₋ₓ₁₂As (0 < x12 ≤ 1). The current confinement region 112i-2 is formed containing, for example, Al₂O₃ (aluminum oxide), and is obtained by oxidizing highly-concentrated Al contained in an oxidized layer 112M (described later) from the side surfaces. The current confinement layer 112i therefore has a function of confining current.

Each of the emitters 112 further includes the ring electrode layer 112K, which is in contact with the contact layer 112H, as illustrated in a in Fig. 3 and b in Fig. 4, for example. In other words, the ring electrode layer 112K is disposed on the side opposite from the light-emitting surface of the substrate 113, and is formed in contact with the top surface of the mesa part 112x. The ring electrode layer 112K is a ring-shaped electrode that is formed in a position that is not opposite the light emitting region of the active layer 112E (or the current injection region 112i-1), and that has an opening in a position that is opposite the light emitting region of the active layer 112E (or the current injection region 112i-1). The ring electrode layer 112K is in contact with a part of the contact layer 112H that is not opposite the light emitting region of the active layer 112E (or the current injection region 112i-1). The ring electrode layer 112K is therefore electrically connected to the DBR layer 112G by the contact layer 112H. The ring electrode layer 112K is formed containing an alloy. The ring electrode layer 112K is formed containing an alloy that is in contact with the contact layer 112H, for example, and is a layered body formed by layering AuGe, Ni, and Au in that order from the contact layer 112H side, for example.

Each of the emitters 112 further includes the metal layer 112L, which is in contact with the ring electrode layer 112K, as illustrated in a in Fig. 3 and a in Fig. 4, for example. The metal layer 112L is formed so as to block an opening in the ring electrode layer 112K, and an outer edge part of the metal layer 112L (a part that is not opposite the current injection region 112i-1) is in contact with the ring electrode layer 112K. The metal layer 112L is therefore electrically connected to the DBR layer 112G by the ring electrode layer 112K and the contact layer 112H. The metal layer 112L is also in contact with the solder bumps 114, and is electrically connected to the laser driver IC 120 by the solder bumps 114. In this figure, 114-1 indicates a barrier metal 114-1 on the laser driver IC 120 side, which is, for example, a layered body of Ni and Cu. The metal layer 112L is electrically connected to an NMOS within the laser driver IC 120, for example. The metal layer 112L is constituted by a non-alloy, and is a layered body formed by layering various types of metal layers in order from the ring electrode layer 112K side.

b in Fig. 3 is a diagram illustrating an example of the configuration of the metal layer 112L. The metal layer 112L is constituted by a reflective metal 112L-2 and a connecting electrode 112L-1. The reflective metal 112L-2 is formed on the substrate 113 side, and functions as an anode electrode of the emitter 112. A layered film in which Ti (titanium) and Au (gold) are layered is used as the reflective metal 112L-2, for example.

The connecting electrode 112L-1 is formed between the reflective metal 112L-2 and the solder bumps 114. The connecting electrode 112L-1 is constituted by a solder wet layer 410, a solder barrier layer 420, and an adhesive layer 430 layered in the Z-axis direction.

The solder wet layer 410 is a layer connected to the solder bumps 114, and has a function of suppressing oxidation of the top surface of the emitter 112. The solder wet layer 410 contains at least one of Au (gold), Pt (platinum), or Cu (copper), for example. In b in Fig. 3, only Au is used. In addition, the thickness of the solder wet layer 410 is 5 to 100 nanometers (nm), for example. However, if the solder wet layer 410 is too thick, the metal of the solder wet layer 410 (Au or the like) will diffuse into the solder bumps 114 and cause voids, and it is therefore necessary to control the thickness of the solder wet layer 410 in accordance with the amount of solder used on the laser driver IC 120 side.

The solder barrier layer 420 is formed between the solder wet layer 410 and the adhesive layer 430. The solder barrier layer 420 contains at least one of Co (cobalt), Pt, Ta (tantalum), or W (tungsten), for example. In b in Fig. 3, only Co is used. Co diffuses slowly into solder, and remains even after being left at high temperatures or after reflow. Separation is therefore less likely to occur. For Ta, W, and the like too, the diffusion is slower than that of Pt, which makes it possible to suppress separation. The thickness of the solder barrier layer 420 is 100 to 500 nanometers (nm), for example.

The adhesive layer 430 is formed between the contact layer 112H and the solder barrier layer 420. The adhesive layer 430 is a layer constituted by two layers, namely a Ti (titanium) layer and a TiN (titanium nitride) layer, or a TaN (tantalum nitride) layer. In the figure, for example, a Ti layer 432 and TiN layer 431 are used. The Ti layer 432 is formed on the substrate 113 side. The thickness of the Ti layer 432 is 10 to 100 nanometers (nm), for example, and the thickness of the TiN layer 431 is 10 to 100 nanometers (nm).

The reflective metal 112L-2 and the connecting electrode 112L-1 may be patterned together through a lift-off technique, or the sizes of the reflective metal 112L-2 and the connecting electrode 112L-1 may be changed by performing the patterning separately.

Using the Ti layer 432 and the TiN layer 431, or the TaN layer, as the adhesive layer 430 eliminates the interface between Ti and Pt even when the solder barrier layer 420 is Pt, which makes it possible to prevent separation, as compared to when only Ti is used as the adhesive layer.

As illustrated in a in Fig. 3, the metal layer 112L is not in direct contact with the top surface of the mesa part 112x (the contact layer 112H). A central part of the metal layer 112L (the part opposite the current injection region 112i-1) is layered on the top surface of the mesa part 112x (the contact layer 112H) over the insulating film 115a (described later). The central part of the metal layer 112L and the insulating film 115a are provided in a position opposite the light emitting region of the active layer 112E (or the current injection region 112i-1), which, seen from the active layer 112E, corresponds to an end of a reflective mirror on the DBR layer 112G side.

Each of the emitters 112 further includes the electrode layer 117, which is in contact with the contact layer 112A, as illustrated in a in Fig. 3, for example. The electrode layer 117 is disposed on the surface of the substrate 113 on the side opposite from the light-emitting surface, and is in contact with a position of the contact layer 112A that is not opposite the mesa part 112x. The electrode layer 117 is in contact with a part of the contact layer 112A that corresponds to a base area of the mesa part 112x, for example. The electrode layer 117 is therefore electrically connected to the DBR layer 112C by the contact layer 112A. The electrode layer 117 is constituted by a non-alloy, and is a layered body formed by layering Ti, Pt, and Au in order from the contact layer 112A side, for example.

Fig. 5 illustrates an example of the planar configuration when the laser driver IC 120 is mounted on a printed circuit board 140. In the surface-emitting laser apparatus 100, a system controller 130 is provided on a printed circuit board 140 in addition to the laser driver IC 120, for example. Fig. 6 illustrates an example of the cross-sectional configuration seen along the line A-A in Fig. 5. A bonding layer 143 is provided between the laser driver IC 120 and the printed circuit board 140. The bonding layer 143 secures the laser driver IC 120 and the printed circuit board 140 to each other. The bonding layer 143 is constituted by an insulative resin material, for example.

The laser driver IC 120 and the printed circuit board 140 are electrically connected by bonding wires 144. One end of each of the bonding wires 144 is secured to a connection pad 122c of the laser driver IC 120, and the other end of each of the bonding wires 144 is connected to a connection pad 141 of the printed circuit board 140.

### [Manufacturing Method]

A method for manufacturing the surface-emitting laser apparatus 100 according to the present embodiment will be described next. Figs. 7 to 16 illustrate an example of the method for manufacturing the laser chip 110 in the surface-emitting laser apparatus 100.

To manufacture the laser chip 110, a compound semiconductor is formed on the substrate 113, which is constituted by GaAs, for example, at once through an epitaxial crystal growth technique such as Metal Organic Chemical Vapor Deposition (MOCVD), for example. A methyl organic metal gas such as trimethyl aluminum (TMAl), trimethyl gallium (TMGa), trimethyl indium (TMIn), or the like, and arsine (AsH₃) gas, are used as the materials for the compound semiconductor, disilane (Si₂H₆) is used as the material for the donor impurity, and carbon tetrabromide (CBr4) is used as the material for the acceptor impurity, for example.

First, the contact layer 112A, the etching stop layer 112B, the DBR layer 112C containing the oxidized layer 112M, the spacer layer 112D, the active layer 112E, the spacer layer 112F, the DBR layer 112G, and the contact layer 112H are formed in that order on the surface of the substrate 113 through an epitaxial crystal growth technique such as MOCVD, for example (Fig. 7). Next, after forming a resist layer (not shown) in a predetermined pattern, for example, the contact layer 112H, the DBR layer 112G, the spacer layer 112F, the active layer 112E, the spacer layer 112D, and the DBR layer 112C are selectively etched using the resist layer as a mask. At this time, it is preferable to use Reactive Ion Etching (RIE) with a Cl-based gas, for example. As a result, the cylindrical mesa part 112x which reaches the surface of the etching stop layer 112B, and a pedestal part 116, are formed, as illustrated in Fig. 8, for example. The oxidized layer 112M is exposed on the side surfaces of the mesa part 112x as this time. The resist layer is then removed.

An oxidation process is then performed at a high temperature in a water vapor atmosphere, and the Al contained in the oxidized layer 112M is selectively oxidized from the side surfaces of the mesa part 112x. Alternatively, a wet oxidation technique is used to selectively oxidize the Al contained in the oxidized layer 112M from the side surfaces of the mesa part 112x. As a result, within the mesa part 112x, an outer edge region of the oxidized layer 112M becomes an insulating layer (aluminum oxide), and the current confinement layer 112i is formed as a result (Fig. 9).

The ring electrode layer 112K is then formed on the top surface of the mesa part 112x (a in Fig. 10). b in Fig. 10 is an enlarged view of the location where the ring electrode layer 112K is formed in a in Fig. 10. The shape of the ring electrode layer 112K in a in Fig. 10 is different from that in b in Fig. 10, but for descriptive purposes, the shape of the electrode is represented schematically in a in Fig. 10.

As illustrated in a in Fig. 11, a lift-off resist 500 is applied in the periphery of the ring electrode layer 112K. As illustrated in b in Fig. 11, the reflective metal 112L-2, such as Ti/Au, is formed by sputtering, vapor deposition, or the like. As illustrated in c in Fig. 11, the connecting electrode 112L-1, such as TiN/Ti/Co/Au, is formed by sputtering, vapor deposition, or the like. As illustrated in d in Fig. 11, the lift-off resist 500 is then removed (i.e., lifted off).

The insulating film 115a is then formed, using CVD or the like, having an opening in the part opposite the ring electrode layer 112K and the base area of the mesa part 112x, for example. In this manner, a plurality of emitters 112 are formed on the contact layer 112A.

Next, an electrode layer 118 is formed on the pedestal part 116 using, for example, vapor deposition, sputtering, or the like (Fig. 12). Next, for example, a plating technique is used to form a connecting layer 119 that connects the electrode layer 117 of each emitter 112 with the electrode layer 118 on the pedestal part 116 (Fig. 13). Note that before using the plating technique, a ground layer serving as the seed for the plating is formed at the part of the insulating film 115a where the connecting layer 119 is to be formed, using vapor deposition, sputtering, or the like, for example. The thickness of the connecting layer 119 is a thickness that can sufficiently prevent a voltage drop (e.g., about 2 pm).

Next, after removing a part of the insulating film 115a subjected to dicing, an insulating film 115b covering the side surfaces of each emitter 112 and the surface of the connecting layer 119 is formed using CVD or the like, for example (Fig. 14). Then, for example, after the substrate 113 is thinned using a grinder or the like, the AR, layer 113A is formed on the back surface of the substrate 113 using CVD, sputtering, or the like, for example. Finally, the substrate 113 is diced. The laser chip 110 is manufactured in this manner.

In the example described above, the ring electrode layer 112K, the reflective metal 112L-2, the electrode layers 117 and 118, and the like are formed after the mesa part 112x is formed, but the order of formation is not limited thereto. The mesa part 112x can also be formed after the ring electrode layer 112K, the reflective metal 112L-2, and the electrode layers 117 and 118 are formed.

In this manner, according to the first embodiment of the present technique, the connecting electrode 112L-1 constituted by the Ti/TiN or TaN adhesive layer 430, the solder barrier layer 420, and the solder wet layer 410 is formed, which means there is no Pt/Ti interface, even if the solder barrier layer 420 is Pt. This makes it possible to prevent separation and improve the reliability of the connection compared to when only Ti is used as the adhesive layer 430.

### <2. Second Embodiment>

Although a Ti/TiN or TaN adhesive layer 430 was formed in the foregoing first embodiment, the configuration is not limited thereto, and the adhesive layer 430 can also be Ti only. The surface-emitting laser apparatus 100 of a second embodiment is different from that of the first embodiment in that the adhesive layer 430 is only Ti.

Fig. 15 is a cross-sectional view illustrating an example of the configuration of the metal layer 112L according to the second embodiment of the present technique. In the second embodiment, the adhesive layer 430 is constituted only by Ti. Also, in the second embodiment, the solder barrier layer 420 does not contain Pt, and contains at least one of Co, Ta, or W, for example. Co is used in the figure.

The solder wet layer 410 of the second embodiment includes at least one of Au, Pt, or Cu, as in the first embodiment. Only Au is used in the figure.

In this manner, according to the second embodiment of the present technique, the solder barrier layer 420 including at least one of Co, Ta, or W is formed between the Ti adhesive layer 430 and the solder wet layer 410, thereby eliminating the Pt/Ti interface. This makes it possible to prevent separation and improve the reliability of the connection compared to when the solder barrier layer 420 contains Pt.

### <3. Application Example>

An example of the application of the surface-emitting laser apparatus 100 according to each of the foregoing embodiments will be described hereinafter.

Fig. 16 illustrates an example of the overall configuration of a distance measurement apparatus 200 including the surface-emitting laser apparatus 100. The distance measurement apparatus 200 measures the distance to a subject 300 using the Time Of Flight (TOF) method. The distance measurement apparatus 200 includes the surface-emitting laser apparatus 100 as a light source. The distance measurement apparatus 200 includes, for example, the surface-emitting laser apparatus 100, a light-receiving apparatus 220, lenses 210 and 230, a signal processing unit 240, a control unit 250, a display unit 260, and a storage unit 270.

The light-receiving apparatus 220 detects light reflected by the subject 300. The lens 210 is a lens for converting light emitted from the surface-emitting laser apparatus 100 into parallel light, and is a collimate lens. The lens 230 is a lens for focusing light reflected by the subject 300 and guiding that light to the light-receiving apparatus 220, and is a focusing lens.

The signal processing unit 240 is a circuit for generating a signal corresponding to a difference between a signal input from the light-receiving apparatus 220 and a reference signal input from the control unit 250. The control unit 250 is configured including a Time to Digital Converter (TDC), for example. The reference signal may be a signal input from the control unit 250, or may be an output signal from a detection unit that directly detects the output of the surface-emitting laser apparatus 100. The control unit 250 is, for example, a processor that controls the surface-emitting laser apparatus 100, the light-receiving apparatus 220, the signal processing unit 240, the display unit 260, and the storage unit 270. The control unit 250 is a circuit that measures the distance to the subject 300 based on the signal generated by the signal processing unit 240. The control unit 250 generates an image signal for displaying information about the distance to the subject 300, and outputs the image signal to the display unit 260. The display unit 260 displays the information about the distance to the subject 300 based on the image signal input from the control unit 250. The control unit 250 stores the information about the distance to the subject 300 in the storage unit 270.

In this application example, the surface-emitting laser apparatus 100 is applied in the distance measurement apparatus 200. This makes it possible to use the distance measurement apparatus 200 while consuming a low amount of power.

### <4. Example of Application in Moving Body>

The technique according to the present disclosure (the present technique) can be applied in various products. For example, the technique according to the present disclosure may be realized as a device mounted on any type of moving body such as an automobile, an electric automobile, a hybrid electric automobile, a motorcycle, a bicycle, a personal mobility device, an airplane, a drone, a ship, a robot, or the like.

Fig. 17 is a block diagram schematically illustrating an example of the configuration of a vehicle control system, which is an example of a moving body control system to which the technique according to the present disclosure can be applied.

A vehicle control system 12000 includes a plurality of electronic control units connected over a communication network 12001. In the example illustrated in Fig. 17, the vehicle control system 12000 includes a drive system control unit 12010, a body system control unit 12020, a vehicle exterior information detection unit 12030, a vehicle interior information detection unit 12040, and an integrated control unit 12050. In addition, a microcomputer 12051, a sound/image output unit 12052, and an in-vehicle network interface (I/F) 12053 are illustrated as functional configurations of the integrated control unit 12050.

The drive system control unit 12010 controls operations of devices related to a drive system of the vehicle according to various types of programs. For example, the drive system control unit 12010 functions as control devices, such as a driving force generation device for generating driving force for the vehicle, such as an internal combustion engine or a driving motor; a driving force transmission mechanism for transmitting driving force to wheels; a steering mechanism for adjusting a turning angle of the vehicle; a braking device that generates braking force for the vehicle; and the like.

The body system control unit 12020 controls the operations of various devices mounted in the vehicle body in accordance with various programs. For example, the body system control unit 12020 functions as control devices for a keyless entry system, a smart key system, power window devices, or various lamps such as headlights, backup lights, brake lights, turn signals, fog lights, and the like. In this case, radio waves emitted from a portable device that substitutes for a key or signals from various switches can be input to the body system control unit 12020. The body system control unit 12020 receives the input of the radio waves or signals and controls door lock devices, power window devices, the lamps, and the like of the vehicle.

The vehicle exterior information detection unit 12030 detects information on the exterior of the vehicle in which the vehicle control system 12000 is installed. For example, an image capturing unit 12031 is connected to the vehicle exterior information detection unit 12030. The vehicle exterior information detection unit 12030 causes the image capturing unit 12031 to capture an image of the exterior of the vehicle, and receives the captured image. The vehicle exterior information detection unit 12030 may perform object detection processing or distance detection processing for people, cars, obstacles, signs, letters on the road, and the like based on the received image.

The image capturing unit 12031 is an optical sensor that receives light and outputs an electrical signal according to the intensity of the received light. The image capturing unit 12031 can also output the electrical signal as an image or as distance measurement information. In addition, the light received by the image capturing unit 12031 may be visible light or non-visible light such as infrared light.

The vehicle interior information detection unit 12040 detects information on the interior of the vehicle. For example, a driver state detection unit 12041 that detects a state of a driver is connected to the vehicle interior information detection unit 12040. The driver state detection unit 12041 includes, for example, a camera that captures an image of the driver, and the vehicle interior information detection unit 12040 may calculate the level of the driver's fatigue or concentration, or may determine whether the driver is dozing, based on detection information input from the driver state detection unit 12041.

For example, the microcomputer 12051 can calculate control target values for a driving force generation device, a steering mechanism, or a braking device based on information on the inside and outside of the vehicle obtained by the vehicle exterior information detection unit 12030 and the vehicle interior information detection unit 12040, and output control commands to the drive system control unit 12010. For example, the microcomputer 12051 can perform coordinated control for the purpose of implementing functions of an Advanced Driver Assistance System (ADAS) including vehicle collision avoidance, impact mitigation, following traveling based on an inter-vehicle distance, constant vehicle speed driving, vehicle collision warnings, and lane departure warnings.

Additionally, the microcomputer 12051 can perform coordinated control for the purpose of automated driving or the like in which autonomous travel is performed without requiring operations of the driver, by controlling the driving force generation device, the steering mechanism, the braking device, or the like based on information about the surroundings of the vehicle, the information being obtained by the vehicle exterior information detection unit 12030 or the vehicle interior information detection unit 12040.

In addition, the microcomputer 12051 can output control commands to the body system control unit 12020 based on the information on the exterior of the vehicle obtained by the vehicle exterior information detection unit 12030. For example, the microcomputer 12051 can perform coordinated control for the purpose of suppressing glare, such as switching from high beams to low beams by controlling the headlights according to the position of a preceding vehicle or an oncoming vehicle detected by the vehicle exterior information detection unit 12030.

The sound/image output unit 12052 transmits an output signal of at least one of sound and an image to an output device capable of visually or audibly providing information to an occupant or to the exterior of the vehicle. In the example illustrated in Fig. 17, an audio speaker 12061, a display unit 12062, and an instrument panel 12063 are illustrated as examples of the output device. The display unit 12062 may include at least one of an on-board display and a heads-up display, for example.

Fig. 18 is a diagram illustrating an example of an installation position of the image capturing unit 12031.

In Fig. 18, image capturing units 12101, 12102, 12103, 12104, and 12105 are provided as the image capturing unit 12031.

The image capturing units 12101, 12102, 12103, 12104, and 12105 are provided at the positions of the front nose, the side-view mirrors, the rear bumper, the trunk door, an upper part of the windshield within the vehicle cabin, and the like of a vehicle 12100, for example. The image capturing unit 12101 provided on the front nose and the image capturing unit 12105 provided in an upper part of the windshield within the vehicle cabin mainly obtain images from in front of the vehicle 12100. The image capturing units 12102 and 12103 provided in the side-view mirrors mainly obtain images from the sides of the vehicle 12100. The image capturing unit 12104 provided on the rear bumper or the trunk door mainly obtains images of an area behind the vehicle 12100. The image capturing unit 12105 provided on an upper part of the windshield within the vehicle cabin is mainly used for detecting preceding vehicles, pedestrians, obstacles, traffic signals, traffic signs, lanes, and the like.

Fig. 18 illustrates an example of image capturing ranges of the image capturing units 12101 to 12104. An image capturing range 12111 indicates an image capturing range of the image capturing unit 12101 provided on the front nose; image capturing ranges 12112 and 12113 respectively indicate the image capturing ranges of the image capturing units 12102 and 12103 provided in the side-view mirrors; and an image capturing range 12114 indicates the image capturing range of the image capturing unit 12104 provided on the rear bumper or the trunk door. For example, by superimposing image data captured by the image capturing units 12101 to 12104, it is possible to obtain a bird's-eye view image seen from above the vehicle 12100.

At least one of the image capturing units 12101 to 12104 may have a function for obtaining distance information. For example, at least one of the image capturing units 12101 to 12104 may be a stereo camera constituted by a plurality of image sensors, or may be an image sensor that has pixels for phase difference detection.

For example, the microcomputer 12051 can extract, particularly, a closest three-dimensional object on a path through which the vehicle 12100 is traveling, which is a three-dimensional object traveling at a predetermined speed (for example, at least 0 km/h) in substantially the same direction as the vehicle 12100, as a preceding vehicle by obtaining a distance to each three-dimensional object in the image capturing ranges 12111 to 12114 and temporal changes in the distance (a relative speed with respect to the vehicle 12100) based on distance information obtained from the image capturing units 12101 to 12104. The microcomputer 12051 can also set an inter-vehicle distance to the preceding vehicle to be maintained in advance and perform automatic brake control (including following stop control) and automatic acceleration control (including following start control). It is therefore possible to perform coordinated control for the purpose of, for example, automated driving in which the vehicle travels in an automated manner without requiring the driver to perform operations.

For example, the microcomputer 12051 can classify and extract three-dimensional data regarding three-dimensional objects as two-wheeled vehicles, normal vehicles, large vehicles, pedestrians, and other three-dimensional objects such as electrical poles based on the distance information obtained from the image capturing units 12101 to 12104, and can use the three-dimensional data to automatically avoid obstacles. For example, the microcomputer 12051 classifies obstacles around the vehicle 12100 into obstacles visible to the driver of the vehicle 12100 and obstacles which are difficult to see. Then, the microcomputer 12051 determines a collision risk indicating the degree of risk of collision with each obstacle, and when the collision risk is at least a set value and there is a possibility of collision, an alarm is output to the driver through the audio speaker 12061 or the display unit 12062, forced deceleration or avoidance steering is performed through the drive system control unit 12010, and the like, making it possible to provide driving assistance for collision avoidance.

At least one of the image capturing units 12101 to 12104 may be an infrared camera that detects infrared rays. For example, the microcomputer 12051 can recognize a pedestrian by determining whether there is a pedestrian in an image captured by the image capturing units 12101 to 12104. Such pedestrian recognition is performed by, for example, a sequence in which feature points in the images captured by the image capturing units 12101 to 12104 as infrared cameras are extracted and a sequence in which pattern matching processing is performed on a series of feature points indicating an outline of an object to determine whether the object is a pedestrian. When the microcomputer 12051 determines that there is a pedestrian in the image captured by the image capturing units 12101 to 12104 and the pedestrian is recognized, the sound/image output unit 12052 controls the display unit 12062 such that a square contour line for emphasis is superimposed on and displayed with the recognized pedestrian. In addition, the sound/image output unit 12052 may control the display unit 12062 such that an icon indicating a pedestrian or the like is displayed at a desired position.

An example of the vehicle control system to which the technique according to the present disclosure can be applied has been described thus far. The technique according to the present disclosure may be applied to the vehicle exterior information detection unit 12030 among the above-described configurations. Applying the technique according to the present disclosure to the vehicle exterior information detection unit 12030 makes it possible to improve the reliability of the vehicle exterior information detection unit 12030.

Note that the embodiments described above are examples of embodiments of the present technique, and the items in the embodiments correspond to the items specifying the invention set forth in the scope of patent claims. Likewise, the items specifying the invention set forth in the scope of patent claims correspond to the items in the embodiments of the present technique which have the same names. However, the present technique is not limited to the embodiments, and can be embodied by making various modifications to the embodiments within a scope that does not depart from the essential spirit thereof.

Note that the effects described in the present specification are merely exemplary and not intended to be limiting, and other effects may be provided as well.

Note that the present technique can also have the following configurations.
(1) A light emitting device including:
   a solder wet layer connected by solder;
   an adhesive layer constituted by one of a tantalum nitride layer and two layers, which are a titanium layer and a titanium nitride layer; and
   a solder barrier layer formed between the solder wet layer and the adhesive layer.
(2) The light emitting device according to (1),
   wherein the solder barrier layer contains at least one of cobalt, platinum, tantalum, and tungsten.
(3) The light emitting device according to (1) or (2),
   wherein the solder wet layer contains at least one of gold, platinum, and copper.
(4) A light emitting device including:
   a solder wet layer connected to a silicon substrate by solder;
   an adhesive layer constituted by a titanium layer; and
   a solder barrier layer containing at least one of cobalt, tantalum, and tungsten, and formed between the solder wet layer and the adhesive layer.
(5) The light emitting device according to (4),
   wherein the solder wet layer contains at least one of gold, platinum, and copper.
(6) A VCSEL on Silicon (VoS) device including:
   a light emitting device including a solder wet layer connected by solder, an adhesive layer constituted by one of a tantalum nitride layer and two layers, which are a titanium layer and a titanium nitride layer, and a solder barrier layer formed between the solder wet layer and the adhesive layer; and
   a silicon substrate on which the light emitting device is provided.
(7) A VCSEL on Silicon (VoS) device including:
   a light emitting device including a solder wet layer connected by solder, an adhesive layer constituted by a titanium layer, and a solder barrier layer containing at least one of cobalt, platinum, tantalum, and tungsten, and formed between the solder wet layer and the adhesive layer; and
   a silicon substrate on which the light emitting device is provided.

### [Reference Signs List]

100 Surface-emitting laser apparatus
110 Laser chip
111 Emitter array
112 Emitter
112A, 112H Contact layer
112B Etching stop layer
112C, 112G DBR layer
112D, 112F Spacer layer
112E Active layer
112i Current confinement layer
112i-1 Current injection region
112i-2 Current confinement region
112K Ring electrode layer
112L Metal layer
112L-1 Connection electrode
112L-2 Reflective metal
112M Oxidized layer
112x Mesa part
113 Substrate
113A Anti-reflection (AR) layer
114 Solder bump
114-1 Barrier metal
115a, 115b Insulating film
116 Pedestal part
117, 118Electrode layer
119 Connection layer
120 Laser driver integrated circuit (IC)
122c Connection pad
130 System controller
140 Printed circuit board
141 Connection pad
143 Bonding layer
144 Bonding wire
200 Distance measurement apparatus
210, 230 Lens
220 Light-receiving apparatus
240 Signal processing unit
250 Control unit
260 Display unit
270 Storage unit
300 Subject
410 Solder wet layer
420 Solder barrier layer
430 Adhesive layer
431 TiN layer
432 Ti layer
500 Lift-off resist
12030 Vehicle exterior information detection unit

## Claims

1. A light emitting device comprising:
a solder wet layer connected by solder;
an adhesive layer constituted by one of a tantalum nitride layer and two layers, which are a titanium layer and a titanium nitride layer; and
a solder barrier layer formed between the solder wet layer and the adhesive layer.

2. The light emitting device according to claim 1,
wherein the solder barrier layer contains at least one of cobalt, platinum, tantalum, and tungsten.

3. The light emitting device according to claim 1,
wherein the solder wet layer contains at least one of gold, platinum, and copper.

4. A light emitting device comprising:
a solder wet layer connected to a silicon substrate by solder;
an adhesive layer constituted by a titanium layer; and
a solder barrier layer containing at least one of cobalt, tantalum, and tungsten, and formed between the solder wet layer and the adhesive layer.

5. The light emitting device according to claim 4,
wherein the solder wet layer contains at least one of gold, platinum, and copper.

6. A VCSEL on Silicon (VoS) device comprising:
a light emitting device including a solder wet layer connected by solder, an adhesive layer constituted by one of a tantalum nitride layer and two layers, which are a titanium layer and a titanium nitride layer, and a solder barrier layer formed between the solder wet layer
and the adhesive layer; and
a silicon substrate on which the light emitting device is provided.

7. A VCSEL on Silicon (VoS) device comprising:
a light emitting device including a solder wet layer connected by solder, an adhesive layer constituted by a titanium layer, and a solder barrier layer containing at least one of cobalt, platinum, tantalum, and tungsten, and formed between the solder wet layer and the adhesive layer; and
a silicon substrate on which the light emitting device is provided.
